# EUROPEAN PATENT SPECIFICATION

(11) **EP 4 283 757 B1**
(45) Date of publication and mention of the grant of the patent: **30.09.2026**
(21) Application number: 22878898.0
(22) Date of filing: 05.10.2022
(51) Int. Cl.: H01M 10/48, H01M 10/44, H01M 10/42, G01R 31/382, G01R 31/392, G01R 31/36, G01R 31/396, G01R 31/387, H02J 7/00, G01R 31/374, H02J 7/82

(54) **SYSTEM AND METHOD FOR ESTIMATING RESIDUAL CAPACITY OF ENERGY STORAGE SYSTEM**
SYSTEM UND VERFAHREN ZUR SCHÄTZUNG DER RESTKAPAZITÄT EINES ENERGIESPEICHERSYSTEMS
SYSTÈME ET PROCÉDÉ D'ESTIMATION DE LA CAPACITÉ RÉSIDUELLE D'UN SYSTÈME DE STOCKAGE D'ÉNERGIE

(30) Priority: 05.10.2021 KR 20210131983
(43) Date of publication of application: 29.11.2023
(73) Proprietor: LG Energy Solution, Ltd., Seoul 07335 (KR)
(72) Inventor: LEE, Chung-Yong, Daejeon 34122 (KR)
(74) Representative: Plasseraud IP
(86) International application number: PCT/KR2022/015014
(87) International publication number: WO 2023/059077

(56) References cited:
- AU-A1- 2020 240 964
- CN-A- 103 499 794
- KR-A- 20120 134 415
- KR-A- 20150 020 958
- KR-A- 20160 067 559
- KR-A- 20210 024 962
- KR-B1- 102 210 716
- US-A1- 2015 046 109
- US-A1- 2016 161 567
- US-A1- 2019 004 118

## Description

### TECHNICAL FIELD

The present disclosure relates to a system and method for estimating the residual capacity of an Energy Storage System (ESS), and more particularly, to a system and method for estimating ESS residual capacity at End Of Life (EOL) by analyzing an actual usage pattern of the ESS.

### BACKGROUND ART

Recently, the use of renewable energy such as sunlight, wind and geothermal heat is gradually increasing due to the environmental pollution issue of fossil fuel. The renewable energy is stored in an energy storage system (ESS). The ESS converts the renewable energy into electrical energy and stores it in batteries, and supplies the electrical energy stored in the batteries to an electrical grid.

In addition to the storage of the renewable energy, the ESS is used to allow homes or factories to store electrical energy of an electrical grid in batteries at times when electricity prices are low to supply the electrical energy stored in the batteries to various types of electric devices during daytime.

The ESS manufacturer pre-acquires the usage pattern (charge/discharge pattern), the daily usage capacity and the usage period of the ESS and designs the End Of Life (EOL) lifespan. The ESS residual capacity decreases with the increasing usage duration. The ESS residual capacity refers to capacity that is available to charge or discharge the ESS. Accordingly, in the design for the EOL lifespan, the ESS manufacturer designs the EOL lifespan of 10, 15, 20 years or longer to make the ESS residual capacity at EOL equal to or higher than the customer's desired usable capacity.

The ESS manufacturer periodically tests the ESS residual capacity after installing the ESS in the field of application. In testing the ESS residual capacity, the test cycle is usually 1 year. The residual capacity test is performed to check if the EOL lifespan can be guaranteed on the basis of the test time.

For example, in case that the EOL lifespan is 20 years and the residual capacity test time is 10 years from the ESS installation time, the test is performed to check if the ESS residual capacity after 10 years is equal to or higher than the customer's desired usable capacity.

When as a result of the test, it is determined that the EOL lifespan is not guaranteed, usage logs of the ESS are obtained and investigation is made to determine if the ESS has been appropriately operated according to the predefined usage pattern.

When it is found that the customer has used the ESS too much more than the usage pattern that was taken into account in the design for the ESS, the ESS manufacturer establishes more ESSs to meet the EOL lifespan or decreases the guaranteed EOL lifespan after consultation with the customer.

The ESS residual capacity testing requires data analysis of large volume. It is necessary to analyze all the previous daily usage patterns of the ESS. Accordingly, the ESS manufacturer has burden of having to pay costs of many human and physical resources required from data acquisition to data analysis.

Accordingly, there is an emergent need for technology that can carry out ESS residual capacity testing in an easy and simple manner in the technical field pertaining to the present disclosure.
Document US 2016/161567 Al: METHOD AND APPARATUS FOR ESTIMATING STATE OF BATTERY.

### DISCLOSURE

### Technical Problem

The present disclosure is designed under the above-described background, and therefore the present disclosure is directed to providing a system and method for estimating the residual capacity of an Energy Storage System (ESS) in which the ESS residual capacity at End Of Life (EOL) is estimated by analyzing a usage pattern of the ESS, and logs about the estimation results are recorded and provided to customers in real time, thereby omitting an ESS residual capacity test process.

### Technical Solution

To achieve the above-described technical objective, the present disclosure includes the examples as defined in the appended set of claims.

### Advantageous Effects

According to the present disclosure, the residual capacity at End Of Life (EOL) is calculated considering each of the actual usage pattern of the Energy Storage System (ESS) and the design usage pattern of the ESS and is stored and managed as log information, thereby omitting the ESS residual capacity test that requires lots of time and costs. Additionally, the ESS residual capacity at EOL may be provided to customers to help the customers to manage the ESS usage pattern or establish additional ESSs. In an example, when the ESS residual capacity at EOL is lower than the design residual capacity, the customer may reduce the daily usage capacity of the ESS or pre-establish an additional ESS at a proper time. In another example, when the ESS residual capacity at EOL is higher than the design residual capacity, the customer may increase the daily usage capacity to increase the usage efficiency of the ESS.

### DESCRIPTION OF DRAWINGS

The accompanying drawings illustrate an exemplary embodiment of the present disclosure, and together with the following detailed description, serve to provide a further understanding of the technical aspects of the present disclosure, and thus the present disclosure should not be construed as being limited to the drawings.
FIG. 1 is a schematic diagram showing the architecture of a system for estimating the residual capacity of an Energy Storage System (ESS) according to an embodiment of the present disclosure.
FIG. 2 is a graph showing an example of an actual usage pattern of an ESS according to an embodiment of the present disclosure.
FIG. 3 is a graph showing an example of a design usage pattern of an ESS according to an embodiment of the present disclosure.
FIGS. 4a and 4b are flowcharts showing the sequence of a method for estimating the residual capacity of an ESS according to an embodiment of the present disclosure.
FIG. 5 is a flowchart showing the sequence of a method for estimating the residual capacity of an ESS according to another embodiment of the present disclosure.

### BEST MODE

Hereinafter, an exemplary embodiment of the present disclosure will be described with reference to the accompanying drawings. Prior to the description, it should be understood that the terms or words used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation. Therefore, the embodiments described herein and illustrations in the drawings are just an exemplary embodiment of the present disclosure and do not fully describe the technical features of the present disclosure, so it should be understood that a variety of other equivalents and modifications could have been made thereto at the time of filing the patent application.

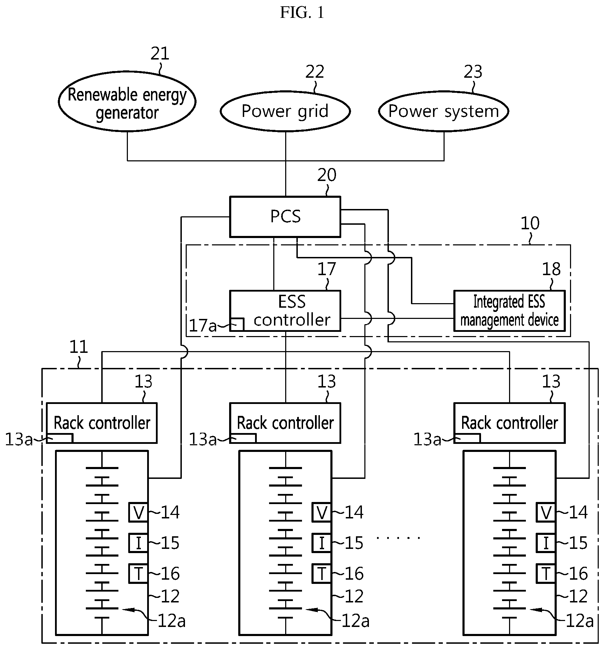

FIG. 1 is a schematic block diagram showing the architecture of a system 10 for estimating the residual capacity of an energy storage system (ESS) according to an embodiment of the present disclosure.

Referring to FIG. 1, the system 10 according to an embodiment of the present disclosure is coupled to the ESS 11 including a plurality of battery racks 12 and a rack controller 13 operably coupled to each battery rack 12.

The battery rack 12 includes a plurality of battery cells 12a. The plurality of battery cells 12a may be connected in series and/or in parallel. The battery cell 12a may be a lithium ion battery, and the present disclosure is not limited by the type of cell.

The battery rack 12 has a known structure in the field of ESS technology. The battery rack 12 includes a rack in which the plurality of battery cells 12a may be mounted and an air conditioner such as a cooling fan to adjust the temperature.

The plurality of battery racks 12 included in the ESS 11 is charged or discharged through a Power Conversion System (PCS) 20. The PCS 20 is a system that takes responsibility for changing the characteristics (frequency, voltage, etc.) of electricity or converting AC-DC to store power supplied from a renewable energy generator 21 using sunlight, wind and geothermal heat and/or a power grid 22 in the ESS 11 or supply energy stored in the ESS 11 to the power grid 22 and/or a power system 23.

Preferably, the battery rack 12 includes a voltage measurement unit 14, a current measurement unit 15 and a temperature measurement unit 16.

The voltage measurement unit 14 measures a cell voltage at regular time intervals during the charging or discharging of the plurality of battery cells 12a, and outputs the cell voltage measurement value to a rack controller 13. The rack controller 13 receives the cell voltage measurement value and records it in a memory device 13a. The voltage measurement unit 14 may include a voltage measurement circuit known in the corresponding technical field.

The current measurement unit 15 measures the magnitude of a charge/discharge current at regular time intervals during the charging or discharging of the plurality of battery cells 12a, and outputs the current measurement value to the rack controller 13. The rack controller 13 receives the measurement value of the charge/discharge current and records it in the memory device 13a. Additionally, the rack controller 13 determines a C-rate of the charge/discharge current and stores it in the memory device 13a. The C-rate of the charge/discharge current may be determined using the magnitude of the charge/discharge current and the capacity of the battery cell 12a. The current measurement unit 15 may be a hall effect sensor or a sense resistor to output a voltage value corresponding to the magnitude of the electric current. The voltage value may be converted into a current value by the Ohm's law.

The temperature measurement unit 16 measures a temperature of the battery rack 12 at regular time intervals during the charging or discharging of the battery rack 12 and outputs the temperature measurement value to the rack controller 13. The rack controller 13 may receive the rack temperature measurement value and store it in the memory device 13a. Since the temperature of the battery rack 12 is uniformly controlled by the air-conditioner, the rack temperature measurement value may be regarded as a temperature measurement value of the battery cell 12a. The temperature measurement unit 16 may directly measure the temperature of the battery cell 12a.

The temperature measurement unit 16 may be a thermocouple or a temperature measurement device to output the voltage value corresponding to the temperature. The voltage value may be converted to the temperature value using a voltage-temperature conversion lookup table (function).

The rack controller 13 may determine a state of charge (SOC) of the battery rack 12 during the charging or discharging of the battery rack 12 and store it in the memory device 13a. The SOC of the battery rack 12 is the sum of SOCs of the battery cells 12a. Accordingly, the rack controller 13 may determine the SOCs of the plurality of battery cells 12a and determine the sum of SOCs as the SOC of the battery rack 12.

In an example, the rack controller 13 may determine the SOC of the battery cell 12a using ampere counting. The initial value of SOC may be determined using open circuit voltage (OCV)-SOC lookup information. That is, when the stop of the charge/discharge of the battery rack 12 is maintained for a predetermined period of time, the rack controller 13 may set the cell voltage measured at the corresponding time as OCV, and determine the initial value of SOC using the OCV-SOC lookup information. The SOC of the battery cell 12a may be determined by accumulating the charge/discharge current on the basis of the initial value of SOC.

In another example, the rack controller 13 may determine the SOC of each battery cell using an extended Kalman filter with input information associated with the voltage, the charge/discharge current and the temperature of the battery cell 12a. The extended Kalman filter used to determine the SOC from the voltage, the charge/discharge current and the temperature of the battery cell is well known in the corresponding technical field.

For the SOC estimation using the extended Kalman filter, for example, reference may be made to Gregory L. Plett's paper titled "Extended Kalman filtering for battery management systems of LiPB-based HEV battery packs Parts 1, 2 and 3" (Journal of Power Source 134, 2004, 252-261), the disclosure of which may be incorporated herein by reference.

The system 10 according to an embodiment of the present disclosure may include an ESS controller 17 operably coupled to the ESS 11.

The ESS controller 17 may be connected to the rack controller 13 through a communication line. Preferably, the communication line may be a line that supports at least one of communication protocols well known in the field of ESS technology, for example, CAN protocol, TCP/IP, Modbus TCP, Modbus RTU, RS-485 or the like.

Selectively, the ESS controller 17 may be connected to the rack controller 13 via near-field communication, for example, Bluetooth, Zigbee, Wifi or the like to enable communication between them.

The ESS controller 17 may be also connected to an integrated ESS management device 18 through the communication line. The integrated ESS management device 18 is a device known as an Energy Management System (EMS) in the field of ESS technology. The integrated ESS management device 18 optimally adjusts the amount and duration of charge/discharge of the ESS 11 through the integrated control of the PCS 20 and the ESS 11. The integrated EMS management device 18 is connected to the sensors and meters, and analyzes the charge/discharge data of the ESS 11 and performs control to operate the ESS 11 with optimum efficiency.

The ESS controller 17 may periodically acquire the SOC of the battery rack 12 from the rack controller 13. To this end, the ESS controller 17 may transmit a SOC request message to the rack controller 13 at regular time intervals. Then, the rack controller 13 may read the SOC of the battery rack 12 from the memory device 13a and transmit it to the ESS controller 17 through the communication line. The ESS controller 17 may store the received SOC of the battery rack 12 in a memory device 17a together with a time stamp. Accordingly, the memory device 17a stores time-series data of the SOC of the battery rack 12.

When the ESS 11 includes the plurality of battery racks 12, the ESS controller 17 may set an average value of SOCs of the battery racks 12 acquired at the same time using the following Equation 1 as a State Of Charge SOC_{ESS} of the ESS 11 and store it in the memory device 17a. Accordingly, the memory device 17a stores time-series data of the State Of Charge SOC_{ESS} of the ESS 11 acquired for a reference time period. ${SOC}_{ESS} = \frac{{\sum }_{k = 1}^{n} {SOC}_{Rack , k}}{n}$

Here, SOC_{ESS} is the SOC of the ESS 11. SOC_{Rack,k} is the SOC of the k-th battery rack 12. n is the total number of battery racks 12.

Each time the reference time period elapses, the ESS controller 17 may determine an actual usage pattern of the ESS 11 indicating a change in SOC of the ESS during the reference time period by referring to the State Of Charge SOC_{ESS} information stored in the memory device 17a, and store the actual usage pattern in the memory device 17a.

Preferably, the reference time period may be 1 day. In this case, each time 1 day elapses, the ESS controller 17 may determine the actual usage pattern of the ESS 11 indicating the change in SOC of the ESS by referring to the time-series data of the State Of Charge SOC_{ESS} periodically stored in the memory device 17a for last 24 hours. In some cases, the reference time period may be set to be longer or shorter than 1 day.

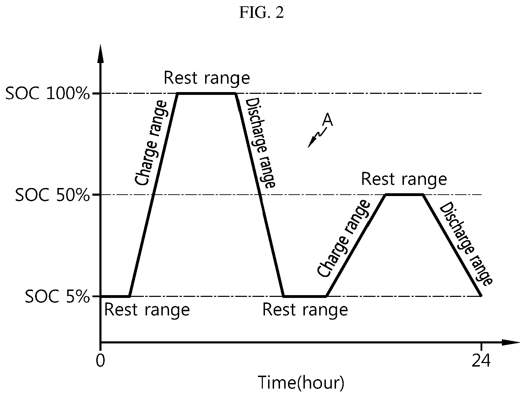

FIG. 2 is a graph showing an example of the actual usage pattern A of the ESS 11 according to an embodiment of the present disclosure.

Referring to FIG. 2, the actual usage pattern A is determined on the basis of 1 day. The actual usage pattern A has two charge ranges, two discharge ranges and four rest ranges, and shows changes in the State Of Charge SOC_{ESS} of the ESS 11 for the reference time period.

The charge range is a range in which the charge power is supplied from the renewable energy generator 21 and/or the power grid 22 to the ESS 11. The time period corresponding to the charge range is the time (nighttime) when the power generation efficiency of renewable energy is high or the power price of the power grid is low. The discharge range is a range in which the discharge power is supplied from the ESS 11 to the power grid 22 and/or the power system 23. The time period corresponding to the discharge range is a peak time of the power grid 22 or the time when the power system 23 needs power (for example, daytime). The time period corresponding to the rest range is a range in which the ESS 11 is stabilized after the charge or discharge of the ESS 11. That is, in the rest range, the battery cell 12a of the battery rack 12 is in stabilized state that polarization is mitigated. The voltage of the battery cell 12a measured at the end of the rest range may be used as OCV when determining the initial value of SOC.

The actual usage pattern A may change depending on how the manager of the ESS 11 implements the usage policy of the ESS 11. When the policy for the active use of the ESS 11 is applied, the discharge range may increase. In contrast, when the policy for the conservative use of the ESS 11 is applied, the discharge range may decrease and the rest range may be extended.

The actual usage pattern A is different from the design usage pattern that was taken into account when determining the EOL lifespan of the ESS 11.

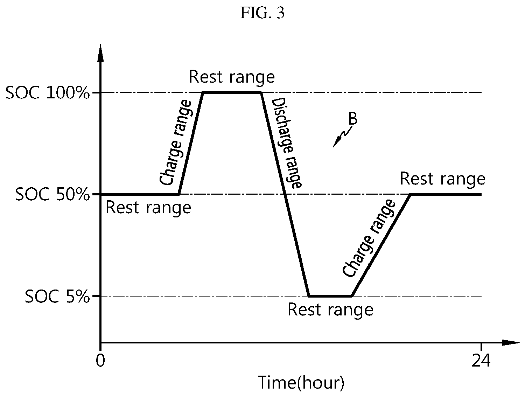

FIG. 3 is a graph showing an example of the design usage pattern B of the ESS 11 according to an embodiment of the present disclosure.

Referring to FIG. 3, the design usage pattern B of an embodiment is determined on the basis of 1 day. The design usage pattern B has charge, discharge and rest ranges, and shows changes in the State Of Charge SOC_{ESS} of the ESS 11 for the reference time period. The EOL lifespan of the ESS 11 is determined on the premise that the ESS 11 is repeatedly charged/discharged according to the design usage pattern.

In case that the actual usage pattern of the reference time period is different from the design usage pattern, a difference of the usage pattern is accumulated, and as a result, the EOL lifespan also changes. The actual usage pattern shown in FIG. 2 has two discharge ranges. Accordingly, when the ESS 11 is repeatedly charged/discharged according to the pattern shown in FIG. 2, the ESS 11 is used more actively than the design usage pattern. Accordingly, when the ESS 11 is repeatedly charged/discharged according to the usage pattern shown in FIG. 2, the ESS residual capacity at EOL is lower than the ESS residual capacity at EOL when the ESS 11 is repeatedly charged/discharged according to the design usage pattern of FIG. 3.

Preferably, the ESS controller 17 may determine a first ESS residual capacity at EOL by applying an average of actual usage patterns determined for each reference time period over the whole period of the EOL lifespan. The first ESS residual capacity corresponds to the estimated residual capacity at EOL when the ESS 11 is repeatedly charged/discharged according to the actual usage pattern.

Specifically, for the k-th reference time period (1 day) (k is a sequence index, and is a natural number of 1 or greater), the ESS controller 17 periodically acquires the State Of Charge SOC_{Rack,k} of the battery rack 12 and the temperature Tₖ and the charge/discharge C-rate cₖ of the battery rack from the rack controller 13 and stores it in the memory device 17a.

Additionally, the ESS controller 17 determines the State Of Charge SOC_{ESS} of the ESS 11 by calculating the average value of State Of Charges SOC_{Rack,k} of the battery racks 12 acquired at the same time using Equation 1 and stores it in the memory device 17a.

Through the above process, the memory device 17a stores the time-series data associated with the State Of Charge SOC_{ESS} of the ESS 11 and the temperature Tₖ and the charge/discharge C-rate cₖ of the plurality of battery racks 12.

The ESS controller 17 determines the actual usage pattern (see FIG. 2) of the ESS 11 using the time-series data of the State Of Charge SOC_{ESS} of the ESS 11 calculated for the k-th reference time period and stores it in the memory device 17a.

Additionally, the ESS controller 17 determines a depth of discharge DoDₖ from the actual usage pattern determined for the k-th reference time period. The depth of discharge DoDₖ corresponds to the sum of SOC changes in each discharge range in the actual usage pattern. As the ESS 11 is actively used, the depth of discharge DoDₖ increases. In contrast, as the ESS 11 is conservatively used, the depth of discharge DoDₖ decreases.

The ESS controller 17 may determine a temperature decay rate A_{T,k} corresponding to the temperature Tₖ of the battery rack using a predefined correlation between temperature T and temperature decay rate A_{T}. The correlation between the temperature T and the temperature decay rate A_{T} may be determined through testing. That is, the correlation between the charge/discharge temperature T and the temperature decay rate A_{T} may be defined as a lookup table or a lookup function by performing the charge/discharge cycling test on the battery cell 12a in different temperature conditions.

The temperature Tₖ used when determining the temperature decay rate A_{T,k} may be the average value of the time-series data of the temperature Tₖ of the plurality of battery racks 12 stored in the memory device 17a, but the present disclosure is not limited thereto. In a variation, the temperature Tₖ may be the maximum, median or mode value of the time-series data of the temperature Tₖ of the battery racks 12 stored in the memory device 17a.

The ESS controller 17 may determine a C-rate decay rate A_{c,k} corresponding to the charge/discharge C-rate cₖ using a predefined correlation between charge/discharge C-rate c and C-rate decay rate A_{c}. The correlation between the charge/discharge C-rate c and the C-rate decay rate A_{c} may be determined through testing. That is, the correlation between the charge/discharge C-rate c and the C-rate decay rate A_{c} may be defined as a lookup table or a lookup function by performing the charge/discharge cycling test on the battery cell 12a in different charge/discharge C-rate conditions.

The charge/discharge C-rate cₖ used when determining the C-rate decay rate A_{c,k} may be the average value of the time-series data of the charge/discharge C-rate cₖ of the plurality of battery racks 12 stored in the memory device 17a, and the present disclosure is not limited thereto. In a variation, the charge/discharge C-rate cₖ may be the maximum, median or mode value of the time-series data of the charge/discharge C-rate cₖ of the plurality of battery racks 12 stored in the memory device 17a.

Additionally, the ESS controller 17 may determine a DoD decay rate A_{DoD,k} corresponding to the depth of discharge DoDₖ determined from the actual usage pattern using a predefined correlation between DoD and DoD decay rate A_{DoD}. The correlation between the DoD and the DoD decay rate A_{DoD} may be determined through testing. That is, the correlation between the DoD and the DoD decay rate A_{DoD} may be defined as a lookup table or a lookup function by performing the charge/discharge cycling test on the battery cell 12a in different DoD conditions.

Additionally, the ESS controller 17 may determine the first ESS residual capacity Capacity₁ at EOL using the following Equation 2 and store it in the memory device 17a. ${Capacity}_{1} = \frac{{\sum }_{k = 1}^{n} {A}_{T , k} {A}_{c , k} {A}_{{DoD ,}_{k}}}{n} ∗ W ∗ A ∗ B ∗ E$

(k: the sequence index of the reference time period, n is the number of reference time periods of the ESS usage duration, W: 'EOL lifespan/reference time period', A_{T,k}: the temperature decay rate for the k-th reference time period, A_{c,k}: the C-rate decay rate for the k-th reference time period, A_{DoD,k}: the DoD decay rate for the k-th reference time period, A: power conversion efficiency (predefined), B: capacity loss compensation ratio (predefined), E: the design capacity of the ESS (predefined))

In Equation 2, the power conversion efficiency A is the power conversion efficiency of the PCS 20, and is a predetermined value according to the performance specification of the PCS 20. The capacity loss compensation ratio is a predefined factor considering the power consumption when the rack controller 13 is supplied with power from the battery rack 12, the power cable loss, the capacity difference between racks and the capacity difference between cells. When the reference time period is 1 day, n is the total number of days for which the ESS 11 has been used, and W is the total number of dates corresponding to the EOL lifespan. In case that the usage duration of the ESS 11 is 10 years and the EOL lifespan is 20 years, n is 365*10 and W is 365*20.

Additionally, the ESS controller 17 may record a first deviation between the first ESS residual capacity Capacity₁ and a reference residual capacity Capacity_{refer} in the memory device 17a.

The reference residual capacity Capacity_{refer} refers to the ESS residual capacity at EOL when the ESS 11 is used over the whole period of the EOL lifespan according to the design usage pattern (FIG. 3).

The reference residual capacity Capacity_{refer} may be pre-calculated through the following Equation 3 and recorded in the memory device 17a for reference. ${Capacity}_{refer} = {A}_{T} ∗ {A}_{c} ∗ {A}_{DoD} ∗ W ∗ A ∗ B ∗ E$

(A_{T}: the temperature decay rate corresponding to the design usage temperature of the ESS, A_{C}: the C-rate decay rate corresponding to the design charge/discharge C-rate of the ESS, A_{DoD}: the DoD decay rate corresponding to the design DoD of ESS, A: the power conversion efficiency (predefined), B: the capacity loss compensation ratio (predefined), E: the design capacity of the ESS (predefined))

In Equation 3, the temperature decay rate A_{T} may be determined using the predefined correlation between the temperature T of the battery rack 12 and the temperature decay rate A_{T}. Additionally, the C-rate decay rate A_{c} may be determined using the predefined correlation between the charge/discharge C-rate c of the battery rack 12 and the C-rate decay rate A_{c}. Additionally, the DoD decay rate A_{DoD} may be determined using the predefined correlation between the DoD and the DoD decay rate A_{DoD}.

Additionally, when an event occurred in which the first deviation between the first ESS residual capacity Capacity₁ and the reference residual capacity Capacity_{refer} is equal to or larger than a first threshold, the ESS controller 17 may record an event log including the occurrence time of the event in the memory device 17a. The first threshold may be set to 1% to 10% level of the reference residual capacity Capacity_{refer}, but the present disclosure is not limited thereto.

Additionally, the ESS controller 17 may be configured to provide the event log to the integrated ESS management device 18. Additionally, the ESS controller 17 may provide the integrated ESS management device 18 with information associated with the first ESS residual capacity Capacity₁, the reference residual capacity Capacity_{refer} and the first deviation between them.

The integrated ESS management device 18 may output the information associated with the first ESS residual capacity Capacity₁, the reference residual capacity Capacity_{refer} and the first deviation between them in a graphical user interface through a display.

Additionally, the integrated ESS management device 18 may output time-series data of the first ESS residual capacity Capacity₁ and time-series data of the first deviation in the form of a graph through the display.

According to another aspect, the ESS controller 17 may determine a second ESS residual capacity Capacity₂ at EOL by applying the average of actual usage patterns determined for each reference time period until the present time, and applying the design usage pattern of the ESS over the remaining period of the EOL lifespan from the present time.

Specifically, the ESS controller 17 periodically acquires the State Of Charge SOC_{Rack,k} of the battery rack 12, and the temperature Tₖ and the charge/discharge C-rate cₖ of the battery rack from the rack controller 13 for the k-th reference time period (1 day) and stores it in the memory device 17a (k is the sequence index, and is a natural number of 1 or greater).

Additionally, the ESS controller 17 determines the State Of Charge SOC_{ESS} of the ESS 11 by calculating the average value of State Of Charges SOC_{Rack,k} of the battery racks 12 acquired at the same time using Equation 1 and stores it in the memory device 17a.

Through the above process, the memory device 17a stores the time-series data associated with the State Of Charge SOC_{ESS} of the ESS 11 and the temperature Tₖ and the charge/discharge C-rate cₖ of the plurality of battery racks 12.

The ESS controller 17 determines the actual usage pattern (see FIG. 2) of the ESS 11 using the time-series data of the State Of Charge SOC_{ESS} of the ESS 11 calculated for the k-th reference time period and stores it in the memory device 17a.

Additionally, the ESS controller 17 determines the depth of discharge DoDₖ from the actual usage pattern determined for the k-th reference time period. The depth of discharge DoDₖ corresponds to the sum of SOC changes in each discharge range in the actual usage pattern. As the ESS 11 is actively used, the depth of discharge DoDₖ increases. In contrast, as the ESS 11 is conservatively used, the depth of discharge DoDₖ decreases.

Additionally, in substantially the same way as the foregoing description, the ESS controller 17 may determine the temperature decay rate A_{T,k} corresponding to the temperature Tₖ of the battery rack, the C-rate decay rate A_{c,k} corresponding to the charge/discharge C-rate cₖ and the DoD decay rate A_{DoD,k} corresponding to the depth of discharge DoDₖ determined from the actual usage pattern.

Additionally, the ESS controller 17 may determine the second ESS residual capacity Capacity₂ at EOL using the following Equation 4 and store it in the memory device 17a. ${Capacity}_{2} = \left(\frac{{\sum }_{k = 1}^{n} {A}_{T , k} {A}_{c , k} {A}_{DoD , k}}{W}∗n+\frac{{A}_{T} {A}_{C} {A}_{DoD}}{W}∗\left(W-n\right)\right) ∗ W ∗ A ∗ B ∗ E$

(k: the sequence index of the reference time period, n is the number of reference time periods of the ESS usage duration, W: 'EOL lifespan/reference time period', A_{T,k}: the temperature decay rate for the k-th reference time period, A_{c,k}: the C-rate decay rate for the k-th reference time period, A_{DoD,k}: the DoD decay rate for the k-th reference time period, A_{T}: the temperature decay rate corresponding to the design usage temperature of the ESS, A_{c}: the C-rate decay rate corresponding to the design charge/discharge C-rate of the ESS, A_{DoD}: the DoD decay rate corresponding to the design DoD of the ESS, A: the power conversion efficiency (predefined), B: the capacity loss compensation ratio (predefined), E: the design capacity of the ESS (predefined))

In Equation 4, the power conversion efficiency A is the power conversion efficiency of the PCS 20, and is a predetermined value according to the performance specification of the PCS 20. The capacity loss compensation ratio is a predefined factor considering the power consumption when the rack controller 13 is supplied with power from the battery rack 12, the power cable loss, the capacity difference between racks and the capacity difference between cells. When the reference time period is 1 day, n is the total number of days for which the ESS 11 has been used, and W is the total number of dates corresponding to the EOL lifespan. In case that the usage duration of the ESS 11 is 10 years and the EOL lifespan is 20 years, n is 365*10 and W is 365*20.

Additionally, the ESS controller 17 may record a second deviation between the second ESS residual capacity Capacity₂ and the reference residual capacity Capacity_{refer} in the memory device 17a.

Additionally, when an event occurred in which the second deviation between the second residual capacity Capacity₂ and the reference residual capacity Capacity_{refer} is equal to or larger than a second threshold, the ESS controller 17 may record an event log including the occurrence time of the event in the memory device 17a. The second threshold may be set to a value of 1% to 10% level of the reference residual capacity Capacity_{refer}, but the present disclosure is not limited thereto.

Additionally, the ESS controller 17 may be configured to provide the event log to the integrated ESS management device 18. Additionally, the ESS controller 17 may provide the integrated ESS management device 18 with information associated with the second ESS residual capacity Capacity₂, the reference residual capacity Capacity_{refer} and the second deviation between them.

The integrated ESS management device 18 may output the information associated with the second ESS residual capacity Capacity₂, the reference residual capacity Capacity_{refer} and the second deviation between them in the graphical user interface through the display.

Additionally, the integrated ESS management device 18 may output time-series data of the second ESS residual capacity Capacity₂ and time-series data of the second deviation in the form of a graph through the display.

According to the above-described embodiment of the present disclosure, since the residual capacity at EOL is calculated considering each of the actual usage pattern of the ESS and the design usage pattern of the ESS and is stored and managed as log information, it is possible to omit the ESS residual capacity test that requires lots of time and costs.

Additionally, since the ESS residual capacity at EOL is calculated based on two standards and provided to the customer, it may be helpful in managing the usage pattern of the ESS and establishing an additional ESS.

In an example, when the ESS residual capacity at EOL is smaller than the reference residual capacity by the threshold or more, the customer may reduce the daily usage capacity of the ESS or pre-establish an additional ESS.

In another example, when the ESS residual capacity at EOL is larger than the reference residual capacity, the customer may increase the daily DoD to increase the usage efficiency of the ESS.

In the present disclosure, the ESS controller 17 may selectively include a processor, application-specific integrated circuit (ASIC), a chipset, a logic circuit, register, a communication modem, a data processing device or the like known in the corresponding technical field to execute various control logics.

The memory devices 13a, 17a is not limited to a particular type, and may include any medium capable of recording and erasing information. In an example, the memory devices 13a, 17a may be hard disk, RAM, ROM, EEPROM, register or flash memory.

The memory devices 13a, 17a may store and/or update and/or erase and/or transmit programs including the control logics performed by the controller and/or data generated when the control logics are executed, predefined lookup tables, functions, parameters, chemical/physical/electrical constants or the like.

At least one of the control logics of the ESS controller 17 may be combined together, and the combined control logics may be written in computer-readable code and recorded in the memory device 17a. The code may be stored and executed in distributed computers connected via a network. Additionally, the functional programs, code and code segments for implementing the combined control logics can be easily inferred by programmers in the technical field pertaining to the present disclosure.

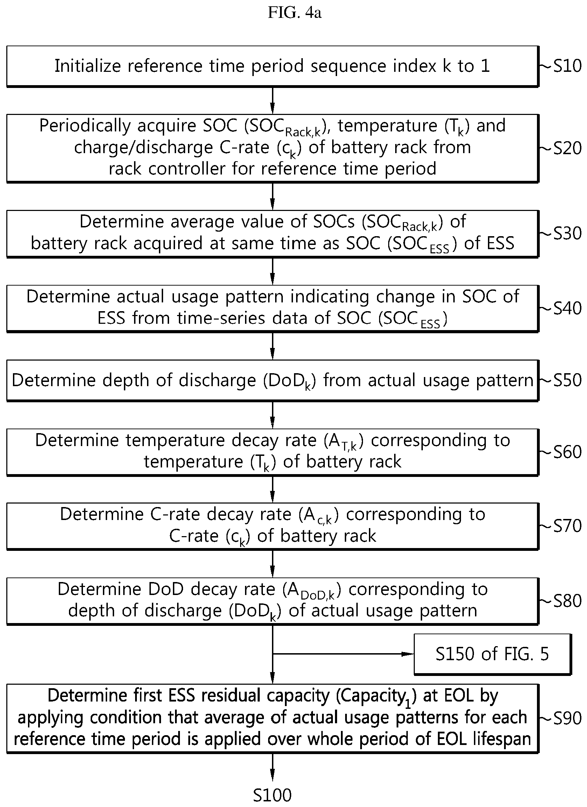

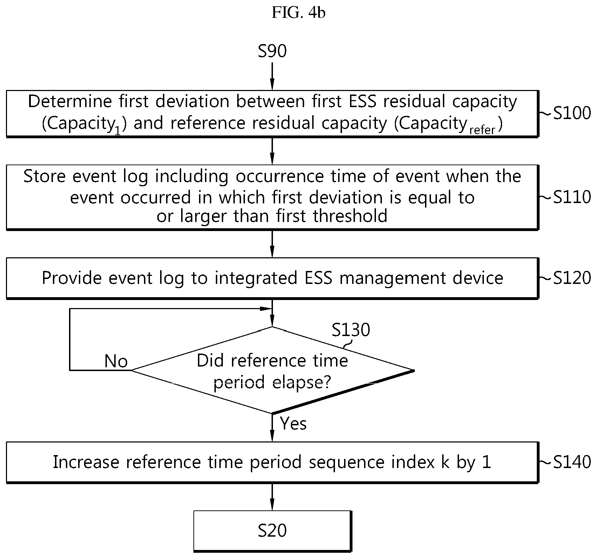

Hereinafter, the method for estimating the residual capacity of the ESS according to an embodiment of the present disclosure will be described in detail with reference to FIGS. 4a and 4b.

FIGS. 4a and 4b are flowcharts showing the sequence of the method for estimating the residual capacity of the ESS according to an embodiment of the present disclosure.

The steps shown in FIGS. 4a and 4b are performed by the ESS controller 17. Additionally, the reference time period is set to 1 day. In some cases, the reference time period may be shorter or longer than 1 day.

Referring to FIGS. 4a and 4b, first, in step S10, the ESS controller 17 initializes the sequence index k of the reference time period to 1.

Subsequently, in step S20, the ESS controller 17 periodically acquires the State Of Charge SOC_{Rack,k}, the temperature Tₖ and the charge/discharge C-rate cₖ of the battery rack 12 from the rack controller 13 for the k-th reference time period (the current value is 1) and stores it in the memory device 17a.

Subsequently, in step S30, the ESS controller 17 sets the average value of State Of Charges SOC_{Rack,k} of the battery racks 12 acquired at the same time as the State Of Charge SOC_{ESS} of the ESS 11 and stores it in the memory device 17a. Accordingly, the memory device 17a stores the time-series data of the State Of Charge SOC_{ESS} of the ESS 11 determined for each reference time period.

Subsequently, in step S40, the ESS controller 17 determines the actual usage pattern of the ESS 11 indicating the change in SOC of the ESS from the time-series data of the State Of Charge SOC_{ESS} stored in the memory device 17a, and stores the actual usage pattern in the memory device 17a.

Subsequently, in step S50, the ESS controller 17 determines the depth of discharge DoDₖ from the actual usage pattern determined for the k-th reference time period.

Subsequently, in step S60, the ESS controller 17 determines the temperature decay rate A_{T,k} corresponding to the temperature Tₖ of the battery rack 12 using the predefined correlation between the temperature T and the temperature decay rate A_{T}. For the temperature Tₖ referenced in determining the temperature decay rate A_{T,k}, the mean, median, maximum or mode value of temperatures of the plurality of battery racks 12 may be used.

Subsequently, in step S70, the ESS controller 17 determines the C-rate decay rate A_{c,k} corresponding to the charge/discharge C-rate cₖ of the battery rack 12 using the predefined correlation between the charge/discharge C-rate c and the C-rate decay rate A_{c}. For the C-rate cₖ referenced in determining the C-rate decay rate A_{c,k}, the mean, median, maximum or mode value of C-rates of the plurality of battery racks 12 may be used.

Subsequently, in step S80, the ESS controller 17 determines the DoD decay rate A_{DoD,k} corresponding to the depth of discharge DoDₖ determined from the actual usage pattern using the predefined correlation between the DoD and the DoD decay rate A_{DoD}.

Subsequently, in step S90, the ESS controller 17 determines the first ESS residual capacity Capacity₁ at EOL by applying the condition that the average of actual usage patterns determined for each reference time period until the present time is applied over the whole period of the EOL lifespan using the following Equation 2, and stores it in the memory device 17a. ${Capacity}_{1} = \frac{{\sum }_{k = 1}^{n} {A}_{T , k} {A}_{c , k} {A}_{{DoD ,}_{k}}}{n} ∗ W ∗ A ∗ B ∗ E$

(k: the sequence index of the reference time period, n is the number of reference time periods of the ESS usage duration, W: 'EOL lifespan/reference time period', A_{T,k}: the temperature decay rate for the k-th reference time period, A_{c,k}: the C-rate decay rate for the k-th reference time period, A_{DoD,k}: the DoD decay rate for the k-th reference time period, A: the power conversion efficiency (predefined), B: the capacity loss compensation ratio (predefined), E: the design capacity of the ESS (predefined))

Subsequently, in step S100, the ESS controller 17 determines the first deviation between the first ESS residual capacity Capacity₁ and the reference residual capacity Capacity_{refer} and stores it in the memory device 17a.

The reference residual capacity Capacity_{refer} refers to the ESS residual capacity at EOL when the ESS 11 is used over the whole period of the EOL lifespan according to the design usage pattern of the ESS 11.

Subsequently, in step S110, when an event occurred in which the first deviation between the first ESS residual capacity Capacity₁ and the reference residual capacity Capacity_{refer} is equal to or larger than the first threshold, the ESS controller 17 may store the event log including the occurrence time of the event in the memory device 17a. The first threshold may be set to 1% to 10% level of the reference residual capacity Capacity_{refer}, but the present disclosure is not limited thereto.

Subsequently, in step S120, the ESS controller 17 provides the event log to the integrated ESS management device 18. The ESS controller 17 may provide the integrated ESS management device 18 with the information associated with the first ESS residual capacity Capacity₁, the reference residual capacity Capacity_{refer} and the first deviation between them together when providing the event log.

Then, the integrated ESS management device 18 may output the information associated with the first ESS residual capacity Capacity₁, the reference residual capacity Capacity_{refer} and the first deviation between them in the graphical user interface through the display.

The integrated ESS management device 18 may output the time-series data of the first ESS residual capacity Capacity₁, and the time-series data of the first deviation in the form of a graph through the display.

After the step S120, step S130 is performed.

In the step S130, the ESS controller 17 determines if the reference time period has elapsed. When the determination of the step S130 is NO, the ESS controller 17 holds the process. In contrast, when the determination of the step S130 is YES, in the step S140, the ESS controller 17 increases the reference time period sequence index k by 1, moves the process to the step S20, and then performs the steps S20 to 120 again for the next reference time period.

Accordingly, each time the reference time period of 1 day elapses, the first ESS residual capacity Capacity₁ is calculated, and when the first deviation between the first ESS residual capacity Capacity₁ and the reference residual capacity Capacity_{refer} is equal to or larger than the first threshold, the event log may be stored in the memory device 17a, and the event log may be provided to the integrated ESS management device 18.

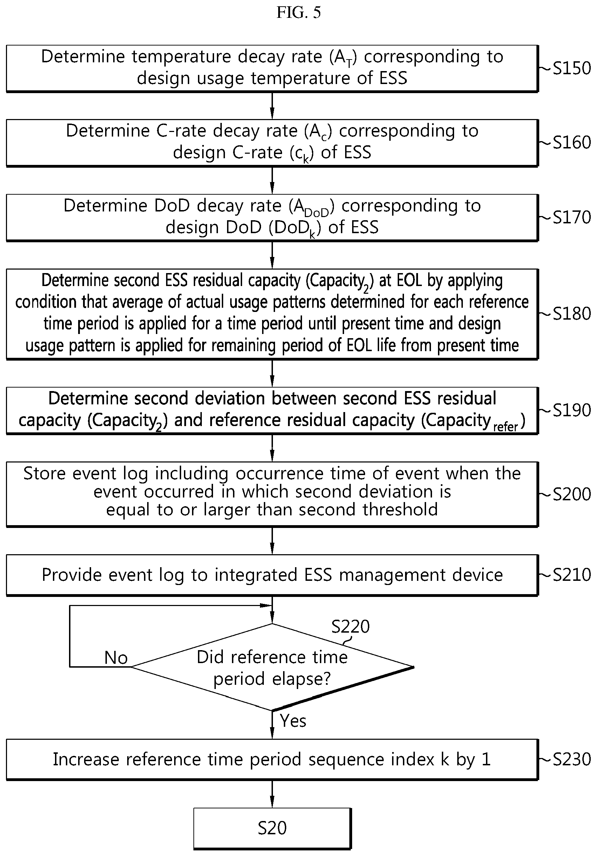

FIG. 5 is a flowchart showing the sequence of the method for estimating the residual capacity of the ESS according to another embodiment of the present disclosure.

In another embodiment, the ESS controller 17 equally performs the steps S10 to S80 of FIG. 4a, and after that, selectively performs the steps S150 to S230 of FIG. 5.

In step S150, the ESS controller 17 determines the temperature decay rate A_{T} corresponding to the design usage temperature of the ESS 11 using the predefined correlation between the temperature T and the temperature decay rate A_{T}.

Subsequently, in step S160, the C-rate decay rate A_{c} corresponding to the design charge/discharge C-rate of the ESS 11 is determined using the predefined correlation between the charge/discharge C-rate c and the C-rate decay rate A_{c}.

Subsequently, in step S170, the DoD decay rate A_{DoD} corresponding to the design DoD of the ESS 11 is determined using the predefined correlation between the DoD and the DoD decay rate A_{DoD}.

Subsequently, in step S180, the ESS controller 17 may determine the second ESS residual capacity Capacity₂ at EOL through the following Equation 4 by applying the condition that the average of actual usage patterns determined for each reference time period is applied for a time period until the present time and the design usage pattern of the ESS is applied for the remaining period of the EOL lifespan from the present time. ${Capacity}_{2} = \left(\frac{{\sum }_{k = 1}^{n} {A}_{T , k} {A}_{c , k} {A}_{DoD , k}}{W}∗n+\frac{{A}_{T} {A}_{C} {A}_{DoD}}{W}∗\left(W-n\right)\right) ∗ W ∗ A ∗ B ∗ E$

(k: the sequence index of the reference time period, n is the number of reference time periods of the ESS usage duration, W: 'EOL lifespan/reference time period', A_{T,k}: the temperature decay rate for the k-th reference time period, A_{c,k}: the C-rate decay rate for the k-th reference time period, A_{DoD,k}: the DoD decay rate for the k-th reference time period, A_{T}: the temperature decay rate corresponding to the design usage temperature of the ESS, A_{c}: the C-rate decay rate corresponding to the design charge/discharge C-rate of the ESS, A_{DoD}: the DoD decay rate corresponding to the design DoD of the ESS, A: the power conversion efficiency (predefined), B: the capacity loss compensation ratio (predefined), E: the design capacity of the ESS (predefined))

Subsequently, in step S190, the ESS controller 17 determines the second deviation between the second ESS residual capacity Capacity₂ and the reference residual capacity Capacity_{refer} and stores it in the memory device 17a.

The reference residual capacity Capacity_{refer} refers to the ESS residual capacity at EOL when the ESS 11 is used over the whole period of the EOL lifespan according to the design usage pattern of the ESS 11.

Subsequently, in step S200, when an event occurred in which the second deviation between the second ESS residual capacity Capacity₂ and the reference residual capacity Capacity_{refer} is equal to or larger than the second threshold, the ESS controller 17 may store the event log including the occurrence time of the event in the memory device 17a. The second threshold may be set to 1% to 10% level of the reference residual capacity Capacity_{refer}, but the present disclosure is not limited thereto.

Subsequently, in step S210, the ESS controller 17 provides the event log to the integrated ESS management device 18. The ESS controller 17 may provide the integrated ESS management device 18 with the information associated with the second ESS residual capacity Capacity₂, the reference residual capacity Capacity_{refer} and the second deviation between them together when providing the event log.

Then, the integrated ESS management device 18 may output the information associated with the second ESS residual capacity Capacity₂, the reference residual capacity Capacity_{refer} and the second deviation between them in the graphical user interface through the display.

The integrated ESS management device 18 may output the time-series data of the second ESS residual capacity Capacity₂ and the time-series data of the second deviation in the form of a graph through the display.

After the step S210, step S220 is performed.

In the step S220, the ESS controller 17 determines if the reference time period has elapsed. When the determination of the step S220 is NO, the ESS controller 17 holds the process. In contrast, when the determination of the step S220 is YES, in step S230, the ESS controller 17 increases the reference time period sequence index k by 1, move the process to the step S20 and performs the steps S20 to 80 of FIG. 4a and the steps S150 to S210 of FIG. 5 again for the next reference time period.

Accordingly, each time the reference time period of 1 day elapses, the second ESS residual capacity Capacity₂ may be calculated, and when the second deviation between the second ESS residual capacity Capacity₂ and the reference residual capacity Capacity_{refer} is equal to or higher than the second threshold, and the event log may be stored in the memory device 17a, and the event log may be provided to the integrated ESS management device 18.

Preferably, the embodiment of FIGS. 4a and 4b and the embodiment of FIG. 5 may be performed for the reference time period at the same time. Additionally, when the condition is satisfied in which the first deviation is equal to or larger than the first threshold and the second deviation is equal to or larger than the second threshold, the event log may be generated, and recorded in the memory device 17a and provided to the integrated ESS management device 18. Additionally, the integrated ESS management device 18 may output at least one selected from the time-series data of the first ESS residual capacity Capacity₁, the time-series data of the second ESS residual capacity Capacity₂, the time-series data of the first deviation and the time-series data of the second deviation as a graph through the display. Through this, the ESS operator may optimally control the ESS usage pattern to follow the design usage pattern of the ESS 11. Additionally, when there is a large difference between the design usage pattern and the actual usage pattern, the ESS operator may take pre-action, for example, establishing additional ESSs, under the discussion with the ESS manufacturer.

While the present disclosure has been described with regard to a limited number of embodiments and drawings, the present disclosure is not limited thereto and it is obvious to those skilled in the art that various modifications and changes may be made thereto within the technical aspects of the present disclosure and the appended claims thereof.

## Claims

1. A system (10) for estimating a residual capacity of an Energy Storage System, ESS, **characterized in that** the system comprises:
an ESS controller (17) operably coupled to the ESS (11) including a plurality of battery racks (12) and rack controllers (13),
wherein the ESS controller (17) is configured to acquire a state of charge, SOC, of the battery rack (12) from the rack controller (13), determine an actual usage pattern of the ESS (11) indicating a change in SOC of the ESS (11) for each reference time period, determine a first ESS residual capacity at End of Life, EOL, by applying an average of the actual usage patterns over a whole period of an EOL lifespan, and record a first deviation between the first ESS residual capacity and a reference residual capacity.

2. The system for estimating the residual capacity of the ESS (11) according to claim 1, wherein the reference time period is 1 day.

3. The system for estimating the residual capacity of the ESS (11) according to claim 1, wherein the ESS controller (17) is configured to determine a second ESS residual capacity at EOL by applying the average of the actual usage patterns determined for each reference time for a time period until a present time and applying a design usage pattern of the ESS for a remaining period of the EOL lifespan from the present time, and record a second deviation between the second ESS residual capacity and the reference residual capacity.

4. The system for estimating the residual capacity of the ESS (11) according to claim 1, wherein the ESS controller (17) is configured to:
for a k-th reference time period, wherein k is an index,
acquire a temperature and a charge/discharge current rate, C-rate, of the battery rack from the rack controller (13),
determine a temperature decay rate corresponding to the temperature using a predefined correlation between the temperature and the temperature decay rate,
determine a C-rate decay rate corresponding to the charge/discharge C-rate using a predefined correlation between the charge/discharge C-rate and the C-rate decay rate,
determine a Depth Of Discharge, DoD, from the actual usage pattern,
determine a DoD decay rate corresponding to the depth of discharge using a predefined correlation between the DoD and the DoD decay rate, and
determine the first ESS residual capacity using the following Equation: ${Capacity}_{1} = \frac{{\sum }_{k = 1}^{n} {A}_{T , k} {A}_{c , k} {A}_{{DoD ,}_{k}}}{n} ∗ W ∗ A ∗ B ∗ E$ with Capacity₁: the first ESS residual capacity, k: the sequence index of the reference time period, n is a number of reference time periods of an ESS usage duration, W: 'the EOL lifespan/the reference time period', A_{T,k}: the temperature decay rate for the k-th reference time period, A_{c,k}: the C-rate decay rate for the k-th reference time period, A_{DoD,k}: the DoD decay rate for the k-th reference time period, A: a power conversion efficiency, B: a capacity loss compensation ratio, and E: a design capacity of the ESS.

5. The system for estimating the residual capacity of the ESS (11) according to claim 3, wherein the ESS controller (17) is configured to:
for a k-th reference time period, wherein k is an index,
acquire a temperature and a charge/discharge current rate, C-rate, of the battery rack (12) from the rack controller (13),
determine a temperature decay rate corresponding to the temperature using a predefined correlation between the temperature and the temperature decay rate,
determine a C-rate decay rate corresponding to the charge/discharge C-rate using a predefined correlation between the charge/discharge C-rate and the C-rate decay rate,
determine a Depth Of Discharge, DoD, from the actual usage pattern,
determine a DoD decay rate corresponding to the depth of discharge using a predefined correlation between the DoD and the DoD decay rate, and
determine a second ESS residual capacity using the following Equation: ${Capacity}_{2} = \left(\frac{{\sum }_{k = 1}^{n} {A}_{T , k} {A}_{c , k} {A}_{DoD , k}}{W}∗n+\frac{{A}_{T} {A}_{C} {A}_{DoD}}{W}∗\left(W-n\right)\right) ∗ W ∗ A ∗ B ∗ E$ with Capacity₂: the second ESS residual capacity, k: the sequence index of the reference time period, n is a number of reference time periods of a ESS usage duration, W: 'the EOL lifespan/the reference time period', A_{T,k}: the temperature decay rate for the k-th reference time period, A_{c,k}: the C-rate decay rate for the k-th reference time period, A_{DoD,k}: the DoD decay rate for the k-th reference time period, A_{T}: the temperature decay rate corresponding to a design usage temperature of the ESS, A_{C}: the C-rate decay rate corresponding to a design charge/discharge C-rate of the ESS, A_{DoD}: the DoD decay rate corresponding to a design DoD of the ESS, A: a power conversion efficiency, B: a capacity loss compensation ratio, E: a design capacity of the ESS.

6. The system for estimating the residual capacity of the ESS (11) according to claim 1, wherein the ESS controller (17) is configured to record an event log including an occurrence time of an event when the event occurs in which the first deviation is equal to or larger than a first threshold.

7. The system for estimating the residual capacity of the ESS (11) according to claim 3, wherein the ESS controller (17) is configured to record an event log including an occurrence time of an event when the event occurs in which the second deviation is equal to or larger than a second threshold.

8. The system for estimating the residual capacity of the ESS according to claim 6 or 7, further comprising:
an integrated ESS management device (18) operably coupled to the ESS controller (17),
wherein the ESS controller (17) is configured to provide the event log to the integrated ESS management device (18).

9. A method for estimating a residual capacity of an Energy Storage System, ESS, by an ESS controller (17) operably coupled to the ESS (11) including a plurality of battery racks (12) and rack controllers (13), **characterized in that** the method comprises:
(a) acquiring a state of charge, SOC, of the battery rack (12) from the rack controller (13);
(b) determining an actual usage pattern of the ESS (11) indicating a change in SOC of the ESS for each reference time period;
(c) determining a first ESS residual capacity at End of Life, EOL, by applying an average of the actual usage patterns over a whole period of an EOL lifespan; and
(d) recording a first deviation between the first ESS residual capacity and a reference residual capacity.

10. The method for estimating the residual capacity of the ESS (11) according to claim 9, wherein the reference time period is 1 day.

11. The method for estimating the residual capacity of the ESS according to claim 9, further comprising:
determining a second ESS residual capacity at EOL by applying the average of the actual usage patterns for a time period until a present time and applying a design usage pattern of the ESS (11) for a remaining period of the EOL lifespan from the present time; and
recording a second deviation between the second ESS residual capacity and the reference residual capacity.

12. The method for estimating the residual capacity of the ESS (11) according to claim 9, wherein comprises:
for a k-th reference time period, wherein k is an index,
acquiring a temperature and a charge/discharge current rate, C-rate, of the battery rack (12) from the rack controller (13);
determining a temperature decay rate corresponding to the temperature using a predefined correlation between the temperature and the temperature decay rate;
determining a C-rate decay rate corresponding to the charge/discharge C-rate using a predefined correlation between the charge/discharge C-rate and the C-rate decay rate;
determining a Depth Of Discharge, DoD, from the actual usage pattern;
determining a DoD decay rate corresponding to the depth of discharge using a predefined correlation between the DoD and the DoD decay rate; and
determining the first ESS residual capacity using the following Equation: ${Capacity}_{1} = \frac{{\sum }_{k = 1}^{n} {A}_{T , k} {A}_{c , k} {A}_{{DoD ,}_{k}}}{n} ∗ W ∗ A ∗ B ∗ E$ with Capacity₁: the first ESS residual capacity, k: the sequence index of the reference time period, n is a number of reference time periods of an ESS usage duration, W: 'the EOL lifespan/the reference time period', A_{T,k}: the temperature decay rate for the k-th reference time period, A_{c,k}: the C-rate decay rate for the k-th reference time period, A_{DoD,k}: the DoD decay rate for the k-th reference time period, A: a power conversion efficiency, B: a capacity loss compensation ratio, E: a design capacity of the ESS.

13. The method for estimating the residual capacity of the ESS (11) according to claim 11, wherein comprises:
for a k-th reference time period, wherein k is an index,
acquiring a temperature and a charge/discharge current rate, C-rate, of the battery rack (12) from the rack controller (13);
determining a temperature decay rate corresponding to the temperature using a predefined correlation between the temperature and the temperature decay rate;
determining a C-rate decay rate corresponding to the charge/discharge C-rate using a predefined correlation between the charge/discharge C-rate and the C-rate decay rate;
determining a Depth Of Discharge, DoD, from the actual usage pattern;
determining a DoD decay rate corresponding to the depth of discharge using a predefined correlation between the DoD and the DoD decay rate; and
determining a second ESS residual capacity using the following Equation: ${Capacity}_{2} = \left(\frac{{\sum }_{k = 1}^{n} {A}_{T , k} {A}_{c , k} {A}_{DoD , k}}{W}∗n+\frac{{A}_{T} {A}_{C} {A}_{DoD}}{W}∗\left(W-n\right)\right) ∗ W ∗ A ∗ B ∗ E$ with Capacity₂: the second ESS residual capacity, k: the sequence index of the reference time period, n is a number of reference time periods of an ESS usage duration, W: 'the EOL lifespan/the reference time period', A_{T,k}: the temperature decay rate for the k-th reference time period, A_{c,k}: the C-rate decay rate for the k-th reference time period, A_{DoD,k}: the DoD decay rate for the k-th reference time period, A_{T}: the temperature decay rate corresponding to a design usage temperature of the ESS, A_{C}: the C-rate decay rate corresponding to a design charge/discharge C-rate of the ESS, A_{DoD}: the DoD decay rate corresponding to a design depth of discharge of the ESS, A: a power conversion efficiency, B: a capacity loss compensation ratio, E: a design capacity of the ESS.

14. The method for estimating the residual capacity of the ESS (11) according to claim 9, further comprising:
recording an event log including an occurrence time of an event when the event occurs in which the first deviation is equal to or larger than a first threshold.

15. The method for estimating the residual capacity of the ESS (11) according to claim 11, further comprising:
recording an event log including an occurrence time of an event when the event occurs in which the second deviation is equal to or larger than a second threshold.

16. The method for estimating the residual capacity of the ESS (11) according to claim 14 or 15, further comprising:
providing the event log to an integrated ESS management device (18).

## Patentansprüche

1. System (10) zum Schätzen einer Restkapazität eines Energiespeichersystems, ESS, **dadurch gekennzeichnet, dass** das System umfasst:
eine ESS-Steuereinheit (17), die betriebsfähig mit dem ESS (11) gekoppelt ist, das eine Vielzahl von Batteriegestellen (12) und Gestell-Steuereinheiten (13) beinhaltet,
wobei die ESS-Steuereinheit (17) konfiguriert ist, um einen Ladezustand, SOC, des Batteriegestells (12) von der Gestell-Steuereinheit (13) zu erfassen, ein tatsächliches Nutzungsmuster des ESS (11) zu bestimmen, das eine Änderung des SOC des ESS (11) für jeden Referenzzeitraum angibt, eine erste ESS-Restkapazität am Ende der Lebensdauer, EOL, durch Anwenden eines Durchschnitts der tatsächlichen Nutzungsmuster über einen gesamten Zeitraum einer EOL-Lebensspanne zu bestimmen, und eine erste Abweichung zwischen der ersten ESS-Restkapazität und einer Referenz-Restkapazität aufzuzeichnen.

2. System zum Schätzen der Restkapazität des ESS (11) nach Anspruch 1, wobei der Referenzzeitraum 1 Tag beträgt.

3. System zum Schätzen der Restkapazität des ESS (11) nach Anspruch 1, wobei die ESS-Steuereinheit (17) konfiguriert ist, um eine zweite ESS-Restkapazität am EOL durch Anwenden des Durchschnitts der tatsächlichen Nutzungsmuster, die für jeden Referenzzeitraum für einen Zeitraum bis zu einem gegenwärtigen Zeitpunkt bestimmt wurden, und Anwenden eines Auslegungsnutzungsmusters des ESS für einen verbleibenden Zeitraum der EOL-Lebensspanne ab dem gegenwärtigen Zeitpunkt zu bestimmen, und eine zweite Abweichung zwischen der zweiten ESS-Restkapazität und der Referenz-Restkapazität aufzuzeichnen.

4. System zum Schätzen der Restkapazität des ESS (11) nach Anspruch 1, wobei die ESS-Steuereinheit (17) konfiguriert ist, um:
für einen k-ten Referenzzeitraum, wobei k ein Index ist,
eine Temperatur und eine Lade-/Entladestromrate, C-Rate, des Batteriegestells von der Gestell-Steuereinheit (13) zu erfassen,
eine Temperaturabklingrate entsprechend der Temperatur unter Verwendung einer vordefinierten Korrelation zwischen der Temperatur und der Temperaturabklingrate zu bestimmen,
eine C-Raten-Abklingrate entsprechend der Lade-/Entlade-C-Rate unter Verwendung einer vordefinierten Korrelation zwischen der Lade-/Entlade-C-Rate und der C-Raten-Abklingrate zu bestimmen,
eine Entladetiefe, DoD, aus dem tatsächlichen Nutzungsmuster zu bestimmen,
eine DoD-Abklingrate entsprechend der Entladetiefe unter Verwendung einer vordefinierten Korrelation zwischen der DoD und der DoD-Abklingrate zu bestimmen, und
die erste ESS-Restkapazität unter Verwendung der folgenden Gleichung zu bestimmen: ${Kapazität}_{1} = \frac{{\sum }_{k = 1}^{n} {A}_{T , k} {A}_{c , k} {A}_{DoD , k}}{n} ∗ W ∗ A ∗ B ∗ E$ mit Kapazität₁: die erste ESS-Restkapazität, k: der Sequenzindex des Referenzzeitraums, n: eine Anzahl an Referenzzeiträumen einer ESS-Nutzungsdauer, W: 'die EOL-Lebensspanne/der Referenzzeitraum', A_{T,k}: die Temperaturabklingrate für den k-ten Referenzzeitraum, A_{c,k}: die C-Raten-Abklingrate für den k-ten Referenzzeitraum, A_{DoD,k}: die DoD-Abklingrate für den k-ten Referenzzeitraum, A: eine Leistungsumwandlungseffizienz, B: ein Kapazitätsverlust-Kompensationsverhältnis und E: eine Auslegungskapazität des ESS.

5. System zum Schätzen der Restkapazität des ESS (11) nach Anspruch 3, wobei die ESS-Steuereinheit (17) konfiguriert ist, um:
für einen k-ten Referenzzeitraum, wobei k ein Index ist,
eine Temperatur und eine Lade-/Entladestromrate, C-Rate, des Batteriegestells (12) von der Gestell-Steuereinheit (13) zu erfassen,
eine Temperaturabklingrate entsprechend der Temperatur unter Verwendung einer vordefinierten Korrelation zwischen der Temperatur und der Temperaturabklingrate zu bestimmen,
eine C-Raten-Abklingrate entsprechend der Lade-/Entlade-C-Rate unter Verwendung einer vordefinierten Korrelation zwischen der Lade-/Entlade-C-Rate und der C-Raten-Abklingrate zu bestimmen,
eine Entladetiefe, DoD, aus dem tatsächlichen Nutzungsmuster zu bestimmen,
eine DoD-Abklingrate entsprechend der Entladetiefe unter Verwendung einer vordefinierten Korrelation zwischen der DoD und der DoD-Abklingrate zu bestimmen, und
eine zweite ESS-Restkapazität unter Verwendung der folgenden Gleichung zu bestimmen: ${Kapazität}_{2} = \left(\frac{{\sum }_{k = 1}^{n} {A}_{T , k} {A}_{c , k} {A}_{DoD , k}}{W}∗n+\frac{{A}_{T} {A}_{c} {A}_{DoD}}{W}∗\left(W-n\right)\right) ∗ W ∗ A ∗ B ∗ E$ mit Kapazität₂: die zweite ESS-Restkapazität, k: der Sequenzindex des Referenzzeitraums, n: eine Anzahl an Referenzzeiträumen einer ESS-Nutzungsdauer, W: 'die EOL-Lebensdauer/der Referenzzeitraum', A_{T,k}: die Temperaturabklingrate für den k-ten Referenzzeitraum, A_{c,k}: die C-Raten-Abklingrate für den k-ten Referenzzeitraum, A_{DoD,k}: die DoD-Abklingrate für den k-ten Referenzzeitraum, A_{T}: die Temperaturabklingrate, die einer Auslegungsnutzungstemperatur des ESS entspricht, A_{c}: die C-Raten-Abklingrate, die einer Auslegungs-Lade-/Entlade-C-Rate des ESS entspricht, A_{DoD}: die DoD-Abklingrate, die einer Auslegungs-DoD des ESS entspricht, A: eine Leistungsumwandlungseffizienz, B: ein Kapazitätsverlust-Kompensationsverhältnis, E: eine Auslegungskapazität des ESS.

6. System zum Schätzen der Restkapazität des ESS (11) nach Anspruch 1, wobei die ESS-Steuereinheit (17) konfiguriert ist, um ein Ereignisprotokoll aufzuzeichnen, das eine Auftrittszeit eines Ereignisses beinhaltet, wenn das Ereignis eintritt, bei dem die erste Abweichung gleich oder größer als ein erster Schwellenwert ist.

7. System zum Schätzen der Restkapazität des ESS (11) nach Anspruch 3, wobei die ESS-Steuereinheit (17) konfiguriert ist, um ein Ereignisprotokoll aufzuzeichnen, das eine Auftrittszeit eines Ereignisses beinhaltet, wenn das Ereignis eintritt, bei dem die zweite Abweichung gleich oder größer als ein zweiter Schwellenwert ist.

8. System zum Schätzen der Restkapazität des ESS nach Anspruch 6 oder 7, weiter umfassend:
eine integrierte ESS-Verwaltungsvorrichtung (18), die betriebsfähig mit der ESS-Steuereinheit (17) gekoppelt ist,
wobei die ESS-Steuereinheit (17) konfiguriert ist, um das Ereignisprotokoll der integrierten ESS-Verwaltungsvorrichtung (18) bereitzustellen.

9. Verfahren zum Schätzen einer Restkapazität eines Energiespeichersystems, ESS, durch eine ESS-Steuereinheit (17), die betriebsfähig mit dem ESS (11) gekoppelt ist, das eine Vielzahl von Batteriegestellen (12) und Gestell-Steuereinheiten (13) umfasst, **dadurch gekennzeichnet, dass** das Verfahren umfasst:
(a) Erfassen eines Ladezustands, SOC, des Batteriegestells (12) von der Gestell-Steuereinheit (13);
(b) Bestimmen eines tatsächlichen Nutzungsmusters des ESS (11), das eine Änderung des SOC des ESS für jeden Referenzzeitraum angibt;
(c) Bestimmen einer ersten ESS-Restkapazität am Ende der Lebensdauer, EOL, durch Anwenden eines Durchschnitts der tatsächlichen Nutzungsmuster über einen gesamten Zeitraum einer EOL-Lebensspanne; und
(d) Aufzeichnen einer ersten Abweichung zwischen der ersten ESS-Restkapazität und einer Referenz-Restkapazität.

10. Verfahren zum Schätzen der Restkapazität des ESS (11) nach Anspruch 9, wobei der Referenzzeitraum 1 Tag beträgt.

11. Verfahren zum Schätzen der Restkapazität des ESS nach Anspruch 9, weiter umfassend:
Bestimmen einer zweiten ESS-Restkapazität am EOL durch Anwenden des Durchschnitts der tatsächlichen Nutzungsmuster für einen Zeitraum bis zu einem gegenwärtigen Zeitpunkt und Anwenden eines Auslegungsnutzungsmusters des ESS (11) für einen verbleibenden Zeitraum der EOL-Lebensspanne ab dem gegenwärtigen Zeitpunkt; und
Aufzeichnen einer zweiten Abweichung zwischen der zweiten ESS-Restkapazität und der Referenz-Restkapazität.

12. Verfahren zum Schätzen der Restkapazität des ESS (11) nach Anspruch 9, wobei umfasst:
für einen k-ten Referenzzeitraum, wobei k ein Index ist,
Erfassen einer Temperatur und einer Lade-/Entladestromrate, C-Rate, des Batteriegestells (12) von der Gestell-Steuereinheit (13);
Bestimmen einer Temperaturabklingrate entsprechend der Temperatur unter Verwendung einer vordefinierten Korrelation zwischen der Temperatur und der Temperaturabklingrate;
Bestimmen einer C-Raten-Abklingrate entsprechend der Lade-/Entlade-C-Rate unter Verwendung einer vordefinierten Korrelation zwischen der Lade-/Entlade-C-Rate und der C-Raten-Abklingrate;
Bestimmen einer Entladetiefe, DoD, aus dem tatsächlichen Nutzungsmuster;
Bestimmen einer DoD-Abklingrate entsprechend der Entladetiefe unter Verwendung einer vordefinierten Korrelation zwischen der DoD und der DoD-Abklingrate; und
Bestimmen der ersten ESS-Restkapazität unter Verwendung der folgenden Gleichung: ${Kapazität}_{1} = \frac{{\sum }_{k = 1}^{n} {A}_{T , k} {A}_{c , k} {A}_{DoD , k}}{n} ∗ W ∗ A ∗ B ∗ E$ mit Kapazität₁: die erste ESS-Restkapazität, k: der Sequenzindex des Referenzzeitraums, n: eine Anzahl von Referenzzeiträumen einer ESS-Nutzungsdauer, W: 'die EOL-Lebensdauer/der Referenzzeitraum', A_{T,k}: die Temperaturabklingrate für den k-ten Referenzzeitraum, A_{c,k}: die C-Raten-Abklingrate für den k-ten Referenzzeitraum, A_{DoD,k}: die DoD-Abklingrate für den k-ten Referenzzeitraum, A: eine Leistungsumwandlungseffizienz, B: ein Kapazitätsverlust-Kompensationsverhältnis, E: eine Auslegungskapazität des ESS.

13. Verfahren zum Schätzen der Restkapazität des ESS (11) nach Anspruch 11, wobei umfasst:
für einen k-ten Referenzzeitraum, wobei k ein Index ist,
Erfassen einer Temperatur und einer Lade-/Entladestromrate, C-Rate, des Batteriegestells (12) von der Gestell-Steuereinheit (13);
Bestimmen einer Temperaturabklingrate entsprechend der Temperatur unter Verwendung einer vordefinierten Korrelation zwischen der Temperatur und der Temperaturabklingrate;
Bestimmen einer C-Raten-Abklingrate entsprechend der Lade-/Entlade-C-Rate unter Verwendung einer vordefinierten Korrelation zwischen der Lade-/Entlade-C-Rate und der C-Raten-Abklingrate;
Bestimmen einer Entladetiefe, DoD, aus dem tatsächlichen Nutzungsmuster;
Bestimmen einer DoD-Abklingrate entsprechend der Entladetiefe unter Verwendung einer vordefinierten Korrelation zwischen der DoD und der DoD-Abklingrate; und
Bestimmen einer zweiten ESS-Restkapazität unter Verwendung der folgenden Gleichung: ${Kapazität}_{2} = \left(\frac{{\sum }_{k = 1}^{n} {A}_{T , k} {A}_{c , k} {A}_{DoD , k}}{W}∗n+\frac{{A}_{T} {A}_{c} {A}_{DoD}}{W}∗\left(W-n\right)\right) ∗ W ∗ A ∗ B ∗ E$ mit Kapazität₂: die zweite ESS-Restkapazität, k: der Sequenzindex des Referenzzeitraums, n: eine Anzahl von Referenzzeiträumen einer ESS-Nutzungsdauer, W: 'die EOL-Lebensdauer/der Referenzzeitraum', A_{T,k}: die Temperaturabklingrate für den k-ten Referenzzeitraum, A_{c,k}: die C-Raten-Abklingrate für den k-ten Referenzzeitraum, A_{DoD,k}: die DoD-Abklingrate für den k-ten Referenzzeitraum, A_{T}: die Temperaturabklingrate, die einer Auslegungsnutzungstemperatur des ESS entspricht, A_{c}: die C-Raten-Abklingrate, die einer Auslegungs-Lade-/Entlade-C-Rate des ESS entspricht, A_{DoD}: die DoD-Abklingrate, die einer Auslegungs-DoD des ESS entspricht, A: eine Leistungsumwandlungseffizienz, B: ein Kapazitätsverlust-Kompensationsverhältnis, E: eine Auslegungskapazität des ESS.

14. Verfahren zum Schätzen der Restkapazität des ESS (11) nach Anspruch 9, weiter umfassend:
Aufzeichnen eines Ereignisprotokolls, das eine Auftrittszeit eines Ereignisses beinhaltet, wenn das Ereignis eintritt, bei dem die erste Abweichung gleich oder größer als ein erster Schwellenwert ist.

15. Verfahren zum Schätzen der Restkapazität des ESS (11) nach Anspruch 11, weiter umfassend:
Aufzeichnen eines Ereignisprotokolls, das eine Auftrittszeit eines Ereignisses beinhaltet, wenn das Ereignis eintritt, bei dem die zweite Abweichung gleich oder größer als ein zweiter Schwellenwert ist.

16. Verfahren zum Schätzen der Restkapazität des ESS (11) nach Anspruch 14 oder 15, weiter umfassend:
Bereitstellen des Ereignisprotokolls für eine integrierte ESS-Verwaltungsvorrichtung (18).

## Revendications

1. Système (10) pour estimer une capacité résiduelle d'un système de stockage d'énergie, ESS, **caractérisé en ce que** le système comprend :
un contrôleur d'ESS (17) couplé de manière opérationnelle à l'ESS (11) incluant une pluralité de bâtis de batteries (12) et de contrôleurs de bâti (13),
dans lequel le contrôleur d'ESS (17) est configuré pour acquérir un état de charge, SOC, du bâti de batteries (12) auprès du contrôleur de bâti (13), déterminer un profil d'utilisation réel de l'ESS (11) indiquant un changement de SOC de l'ESS (11) pour chaque période de temps de référence, déterminer une première capacité résiduelle d'ESS en fin de vie, EOL, en appliquant une moyenne des profils d'utilisation réels sur une période entière d'une durée de vie EOL, et enregistrer un premier écart entre la première capacité résiduelle d'ESS et une capacité résiduelle de référence.

2. Système pour estimer la capacité résiduelle de l'ESS (11) selon la revendication 1, dans lequel la période de temps de référence est de 1 jour.

3. Système pour estimer la capacité résiduelle de l'ESS (11) selon la revendication 1, dans lequel le contrôleur d'ESS (17) est configuré pour déterminer une seconde capacité résiduelle d'ESS en EOL en appliquant la moyenne des profils d'utilisation réels déterminés pour chaque temps de référence pour une période de temps jusqu'à un instant présent et en appliquant un profil d'utilisation de conception de l'ESS pour une période restante de la durée de vie EOL à partir de l'instant présent, et enregistrer un second écart entre la seconde capacité résiduelle d'ESS et la capacité résiduelle de référence.

4. Système pour estimer la capacité résiduelle de l'ESS (11) selon la revendication 1, dans lequel le contrôleur d'ESS (17) est configuré pour :
pour une k-ième période de temps de référence, où k est un indice,
acquérir une température et un taux de courant de charge/décharge, C-rate, du bâti de batteries auprès du contrôleur de bâti (13),
déterminer un taux de dégradation dû à la température correspondant à la température en utilisant une corrélation prédéfinie entre la température et le taux de dégradation dû à la température,
déterminer un taux de dégradation dû au C-rate correspondant au C-rate de charge/décharge en utilisant une corrélation prédéfinie entre le C-rate de charge/décharge et le taux de dégradation dû au C-rate,
déterminer une profondeur de décharge, DoD, à partir du profil d'utilisation réel,
déterminer un taux de dégradation dû au DoD correspondant à la profondeur de décharge en utilisant une corrélation prédéfinie entre le DoD et le taux de dégradation dû au DoD, et
déterminer la première capacité résiduelle d'ESS en utilisant l'équation suivante : ${Capacity}_{1} = \frac{{\sum }_{k = 1}^{n} {A}_{T , k} {A}_{c , k} {A}_{DoD , k}}{n} ∗ W ∗ A ∗ B ∗ E$ avec Capacity, : la première capacité résiduelle d'ESS, k : l'indice de séquence de la période de temps de référence, n : un nombre de périodes de temps de référence d'une durée d'utilisation d'ESS, W : « la durée de vie EOL/la période de temps de référence », A_{T,k}: le taux de dégradation dû à la température pour la k-ième période de temps de référence, A_{c,k}: le taux de dégradation dû au C-rate pour la k-ième période de temps de référence, A_{DoD,k}: le taux de dégradation dû au DoD pour la k-ième période de temps de référence, A : un rendement de conversion de puissance, B : un rapport de compensation de perte de capacité, et E : une capacité de conception de l'ESS.

5. Système pour estimer la capacité résiduelle de l'ESS (11) selon la revendication 3, dans lequel le contrôleur d'ESS (17) est configuré pour :
pour une k-ième période de temps de référence, où k est un indice,
acquérir une température et un taux de courant de charge/décharge, C-rate, du bâti de batteries (12) auprès du contrôleur de bâti (13),
déterminer un taux de dégradation dû à la température correspondant à la température en utilisant une corrélation prédéfinie entre la température et le taux de dégradation dû à la température,
déterminer un taux de dégradation dû au C-rate correspondant au C-rate de charge/décharge en utilisant une corrélation prédéfinie entre le C-rate de charge/décharge et le taux de dégradation dû au C-rate,
déterminer une profondeur de décharge, DoD, à partir du profil d'utilisation réel,
déterminer un taux de dégradation dû au DoD correspondant à la profondeur de décharge en utilisant une corrélation prédéfinie entre le DoD et le taux de dégradation dû au DoD, et
déterminer une seconde capacité résiduelle d'ESS en utilisant l'équation suivante : ${Capacity}_{2} = \left(\frac{{\sum }_{k = 1}^{n} {A}_{T , k} {A}_{c , k} {A}_{DoD , k}}{W}∗n+\frac{{A}_{T} {A}_{c} {A}_{DoD}}{W}∗\left(W-n\right)\right) ∗ W ∗ A ∗ B ∗ E$ avec Capacity₂ : la seconde capacité résiduelle d'ESS, k : l'indice de séquence de la période de temps de référence, n : un nombre de périodes de temps de référence d'une durée d'utilisation d'ESS, W : « la durée de vie EOL/la période de temps de référence », A_{T,k} : le taux de dégradation dû à la température pour la k-ième période de temps de référence, A_{c,k} : le taux de dégradation dû au C-rate pour la k-ième période de temps de référence, A_{DoD,k} : le taux de dégradation dû au DoD pour la k-ième période de temps de référence, A_{T} : le taux de dégradation dû à la température correspondant à une température d'utilisation de conception de l'ESS, A_{c} : le taux de dégradation dû au C-rate correspondant à un C-rate de charge/décharge de conception de l'ESS, A_{DoD} : le taux de dégradation dû au DoD correspondant à un DoD de conception de l'ESS, A : un rendement de conversion de puissance, B : un rapport de compensation de perte de capacité, E : une capacité de conception de l'ESS.

6. Système pour estimer la capacité résiduelle de l'ESS (11) selon la revendication 1, dans lequel le contrôleur d'ESS (17) est configuré pour enregistrer un journal d'événements incluant une heure d'occurrence d'un événement lorsque l'événement se produit dans lequel le premier écart est égal ou supérieur à un premier seuil.

7. Système pour estimer la capacité résiduelle de l'ESS (11) selon la revendication 3, dans lequel le contrôleur d'ESS (17) est configuré pour enregistrer un journal d'événements incluant une heure d'occurrence d'un événement lorsque l'événement se produit dans lequel le second écart est égal ou supérieur à un second seuil.

8. Système pour estimer la capacité résiduelle de l'ESS selon la revendication 6 ou 7, comprenant en outre :
un dispositif de gestion d'ESS intégré (18) couplé de manière opérationnelle au contrôleur d'ESS (17),
dans lequel le contrôleur d'ESS (17) est configuré pour fournir le journal d'événements au dispositif de gestion d'ESS intégré (18).

9. Procédé pour estimer une capacité résiduelle d'un système de stockage d'énergie, ESS, par un contrôleur d'ESS (17) couplé de manière opérationnelle à l'ESS (11) incluant une pluralité de bâtis de batteries (12) et de contrôleurs de bâti (13), **caractérisé en ce que** le procédé comprend :
(a) l'acquisition d'un état de charge, SOC, du bâti de batteries (12) auprès du contrôleur de bâti (13) ;
(b) la détermination d'un profil d'utilisation réel de l'ESS (11) indiquant un changement de SOC de l'ESS pour chaque période de temps de référence ;
(c) la détermination d'une première capacité résiduelle d'ESS en fin de vie, EOL, en appliquant une moyenne des profils d'utilisation réels sur une période entière d'une durée de vie EOL ; et
(d) l'enregistrement d'un premier écart entre la première capacité résiduelle d'ESS et une capacité résiduelle de référence.

10. Procédé pour estimer la capacité résiduelle de l'ESS (11) selon la revendication 9, dans lequel la période de temps de référence est de 1 jour.

11. Procédé pour estimer la capacité résiduelle de l'ESS selon la revendication 9, comprenant en outre :
la détermination d'une seconde capacité résiduelle d'ESS en EOL en appliquant la moyenne des profils d'utilisation réels pour une période de temps jusqu'à un instant présent et en appliquant un profil d'utilisation de conception de l'ESS (11) pour une période restante de la durée de vie EOL à partir de l'instant présent ;
et
l'enregistrement d'un second écart entre la seconde capacité résiduelle d'ESS et la capacité résiduelle de référence.

12. Procédé pour estimer la capacité résiduelle de l'ESS (11) selon la revendication 9, lequel comprend :
pour une k-ième période de temps de référence, où k est un indice,
l'acquisition d'une température et d'un taux de courant de charge/décharge, C-rate, du bâti de batteries (12) auprès du contrôleur de bâti (13) ;
la détermination d'un taux de dégradation dû à la température correspondant à la température en utilisant une corrélation prédéfinie entre la température et le taux de dégradation dû à la température ;
la détermination d'un taux de dégradation dû au C-rate correspondant au C-rate de charge/décharge en utilisant une corrélation prédéfinie entre le C-rate de charge/décharge et le taux de dégradation dû au C-rate ;
la détermination d'une profondeur de décharge, DoD, à partir du profil d'utilisation réel ;
la détermination d'un taux de dégradation dû au DoD correspondant à la profondeur de décharge en utilisant une corrélation prédéfinie entre le DoD et le taux de dégradation dû au DoD ; et
la détermination de la première capacité résiduelle d'ESS en utilisant l'équation suivante : ${Capacity}_{1} = \frac{{\sum }_{k = 1}^{n} {A}_{T , k} {A}_{c , k} {A}_{DoD , k}}{n} ∗ W ∗ A ∗ B ∗ E$ avec Capacity₁ : la première capacité résiduelle d'ESS, k : l'indice de séquence de la période de temps de référence, n : un nombre de périodes de temps de référence d'une durée d'utilisation d'ESS, W : « la durée de vie EOL/la période de temps de référence », A_{T,k} : le taux de dégradation dû à la température pour la k-ième période de temps de référence, A_{c,k} : le taux de dégradation dû au C-rate pour la k-ième période de temps de référence, A_{DoD,k} : le taux de dégradation dû au DoD pour la k-ième période de temps de référence, A : un rendement de conversion de puissance, B : un rapport de compensation de perte de capacité, E : une capacité de conception de l'ESS.

13. Procédé pour estimer la capacité résiduelle de l'ESS (11) selon la revendication 11, lequel comprend :
pour une k-ième période de temps de référence, où k est un indice,
l'acquisition d'une température et d'un taux de courant de charge/décharge, C-rate, du bâti de batteries (12) auprès du contrôleur de bâti (13) ;
la détermination d'un taux de dégradation dû à la température correspondant à la température en utilisant une corrélation prédéfinie entre la température et le taux de dégradation dû à la température ;
la détermination d'un taux de dégradation dû au C-rate correspondant au C-rate de charge/décharge en utilisant une corrélation prédéfinie entre le C-rate de charge/décharge et le taux de dégradation dû au C-rate ;
la détermination d'une profondeur de décharge, DoD, à partir du profil d'utilisation réel ;
la détermination d'un taux de dégradation dû au DoD correspondant à la profondeur de décharge en utilisant une corrélation prédéfinie entre le DoD et le taux de dégradation dû au DoD ; et
la détermination d'une seconde capacité résiduelle d'ESS en utilisant l'équation suivante : ${Capacity}_{2} = \left(\frac{{\sum }_{k = 1}^{n} {A}_{T , k} {A}_{c , k} {A}_{DoD , k}}{W}∗n+\frac{{A}_{T} {A}_{c} {A}_{DoD}}{W}∗\left(W-n\right)\right) ∗ W ∗ A ∗ B ∗ E$ avec Capacity₂ : la seconde capacité résiduelle d'ESS, k : l'indice de séquence de la période de temps de référence, n : un nombre de périodes de temps de référence d'une durée d'utilisation d'ESS, W : « la durée de vie EOL/la période de temps de référence », A_{T,k} : le taux de dégradation dû à la température pour la k-ième période de temps de référence, A_{c,k} : le taux de dégradation dû au C-rate pour la k-ième période de temps de référence, A_{DoD,k} : le taux de dégradation dû au DoD pour la k-ième période de temps de référence, A_{T} : le taux de dégradation dû à la température correspondant à une température d'utilisation de conception de l'ESS, A_{c} : le taux de dégradation dû au C-rate correspondant à un C-rate de charge/décharge de conception de l'ESS, A_{DoD} : le taux de dégradation dû au DoD correspondant à un DoD de conception de l'ESS, A : un rendement de conversion de puissance, B : un rapport de compensation de perte de capacité, E : une capacité de conception de l'ESS.

14. Procédé pour estimer la capacité résiduelle de l'ESS (11) selon la revendication 9, comprenant en outre :
l'enregistrement d'un journal d'événements incluant une heure d'occurrence d'un événement lorsque l'événement se produit dans lequel le premier écart est égal ou supérieur à un premier seuil.

15. Procédé pour estimer la capacité résiduelle de l'ESS (11) selon la revendication 11, comprenant en outre :
l'enregistrement d'un journal d'événements incluant une heure d'occurrence d'un événement lorsque l'événement se produit dans lequel le second écart est égal ou supérieur à un second seuil.

16. Procédé pour estimer la capacité résiduelle de l'ESS (11) selon la revendication 14 ou 15, comprenant en outre :
la fourniture du journal d'événements à un dispositif de gestion d'ESS intégré (18).
